# EUROPÄISCHE PATENTSCHRIFT

(11) **EP 3 507 880 B1**
(45) Veröffentlichungstag und Bekanntmachung des Hinweises auf die Patenterteilung: **08.07.2026**
(21) Anmeldenummer: 17743326.5
(22) Anmeldetag: 25.07.2017
(51) Int. Cl.: H02H 9/04, G01R 31/12, H02H 1/00, H02H 3/04

(54) **ÜBERSPANNUNGSSCHUTZEINRICHTUNG MIT ÜBERWACHUNGS- UND KOMMUNIKATIONSFUNKTION**
OVERVOLTAGE PROTECTION DEVICE WITH MONITORING AND COMMUNICATION FUNCTIONS
DISPOSITIF DE PROTECTION CONTRE LA SURTENSION PRÉSENTANT UNE FONCTION DE SURVEILLANCE ET DE COMMUNICATION

(30) Priorität: 31.08.2016 DE 102016116210; 29.12.2016 DE 102016125900
(43) Veröffentlichungstag der Anmeldung: 10.07.2019
(73) Patentinhaber: DEHN SE, 92318 Neumarkt i.d. OPf. (DE)
(72) Erfinder: BROCKE, Ralph, 98693 Ilmenau/Oberpörlitz (DE); ZAHLMANN, Peter, 92318 Neumarkt (DE)
(74) Vertreter: Prinz & Partner mbB
(86) Internationale Anmeldenummer: PCT/EP2017/068716
(87) Internationale Veröffentlichungsnummer: WO 2018/041474

(56) Entgegenhaltungen:
- EP-A1- 2 333 925
- WO-A1-2015/055233
- DE-A1- 102009 022 832
- US-A1- 2008 100 436

## Beschreibung

Die Erfindung betrifft ein System enthaltend mehrere vernetzte Überspannungsschutzeinrichtungen mit Überwachungs- und Kommunikationsfunktion für die Informations- und Prozessindustrie mit mindestens einem Überspannungsableiter mit Eigendiagnoseeinheit sowie einer drahtlosen und/oder drahtgebundenen Standardschnittstelle zur Datenübermittlung gemäß Anspruch 1.

Aus der DE 10 2006 034 164 B4 ist ein mehrpoliger Blitzstrom- und/oder Überspannungsableiter in Reihenklemmausführung vorbekannt. Dieser Überspannungsableiter dient bevorzugt dem Schutz von Geräten und Anlagen der Informationstechnik und besteht aus Basisteil, ausgebildet als Durchgangsklemme, und in das Basisteil einsetzbare Steckmodule mit Schutzelementen zur Hutschienenmontage.

Gemäß einer dortigen Ausführungsform ist eine Leiterplatte vorgesehen, welche eine Einrichtung zur drahtlosen Fehler- und Zustandsüberwachung, zum Beispiel in Form eines RFID-Transponders aufweist. Die Leiterplatte kann auch Mittel zur Temperaturüberwachung der auf den übrigen Leiterplatten befindlichen Schutzelementen enthalten. Solche Mittel können Temperatursensoren sein, die jeweils nach, insbesondere gegenüberliegend der Schutzelemente befindlich sind.

Insofern besitzt also der vorbekannte Überspannungsableiter eine Eigendiagnoseeinheit.

Bei dem Smart-Meter gemäß DE 20 2012 010 818 U1 weist Selbiges eine Elektronik zur Erfassung des Stromverbrauches und zur Ausgabe von den Stromverbrauch repräsentierenden Daten über eine Datenkommunikationsschnittstelle auf.

Gemäß bevorzugter Ausführungsform ist eine LAN-Schnittstelle zum Auslesen und Programmieren des Smart-Meters vorgesehen, während wenigstens eine weitere Schnittstelle und die Elektronik des Smart-Meters dazu eingerichtet ist, zur Steuerung sonstiger externer Geräte zu dienen, die dann zum Beispiel über ein Feldbussystem von dem ebenfalls an das Feldbussystem angeschlossenen Smart-Meter gesteuert werden können.

Ebenso besteht die Möglichkeit, in das Gehäuse des Smart-Meters einen Webserver zu integrieren, so dass der von dem Smart-Meter ermittelte Stromverbrauch von externen Geräten, zum Beispiel auch von Mobiltelefonen über eine geeignete Software (App) über das Internet abgefragt werden kann.

Die Überspannungsschutzvorrichtung mit Überwachungsfunktion nach DE 102014 219 913 A1 besitzt eine spezielle Schaltungsanordnung nach Art einer Wheatstone'schen Messbrücke, um den Zustand der dort vorhandenen Überspannungsschutzelemente zeitlich unmittelbar zu erkennen.

Zur Zustandskontrolle können alternativ oder zusätzlich temporäre, aber auch periodisch wiederkehrende Messungen vorgenommen werden.

Eine lokale Signalisierung des Zustandes kann beispielsweise durch ein optisches und/oder akustisches Signal oder ein Display erfolgen. Eine Fernsignalisierung kann durch eine Fernmeldung, zum Beispiel über einen Automatisierungsbus oder allgemein mittels Telekommunikation realisiert werden.

Die WO 2015/055233 A1 zeigt eine Vorrichtung zum Überwachen eines Überspannungsableiters, wobei die Vorrichtung an eine Erdungsleitung angeschlossen ist und eine Messeinheit, eine Verarbeitungseinheit sowie ein Speichermedium umfasst. Es kann eine Kommunikationseinheit vorgesehen sein, welche zum bidirektionalen Datenaustausch mit einer Ausleseeinheit eingerichtet ist, sodass die Vorrichtung Kontrollbefehle von der Ausleseeinheit erhalten kann. Die Vorrichtung ist aus einem Basismodul und einem zerstörungsfrei lösbaren Zusatzmodul zusammengesetzt.

Aus der EP 2 333 925 A1 ist eine Überwachungseinrichtung für einen Überspannungsableiter bekannt, wobei mittels der Überwachungseinrichtung Rückschlüsse auf den Zustand des Überspannungsableiters gezogen werden können, beispielsweise basierend auf der Detektion eines auftretenden Folgestroms. Bei der Beurteilung können auch zusätzliche Parameter einfließen, insbesondere die Umgebungstemperatur sowie die Luftfeuchte. Es können eine Vielzahl von Überwachungseinrichtungen über ein Gateway mit Auswerteeinheiten verbunden sein, beispielsweise über das Internet.

Die US 2008/100436 A1 zeigt ein elektrisches Versorgungsnetz umfassend ein Kommunikationsnetzwerk mit einem Übertragungsnetz und einem Verteilungsnetz. Beide Netze verfügen über eine Vielzahl von Sensorvorrichtungen und können unter anderem Schutzvorrichtungen umfassen. Die Sensorvorrichtungen messen Eigenschaften des elektrischen Netzes und sind über Kommunikationsvorrichtungen mit einem Gateway bidirektional zum Austausch verbunden, wobei das Gateway wiederum mit einer zentralen Kontrolleinheit verbunden ist.

Bei den Lösungen des Standes der Technik gelingt es zwar, unabhängig oder ergänzend zu bekannten thermischen Abtrennvorrichtungen auf Zustandsveränderungen eingesetzte Überspannungsableiter zu reagieren und über Eigendiagnoseeinheiten den erkannten Zustand einer externen Auswertung zuzuführen, die beispielsweise darin besteht, bei vorgesehenen Inspektions-oder Wartungsarbeiten vorgeschädigte Überspannungsableiter vorsorglich auszutauschen.

Eine Nutzung der diesbezüglich gewonnenen Daten für weitere Zwecke bleibt jedoch aus.

Aus dem Vorgenannten ist es Aufgabe der Erfindung, eine weiterentwickelte Überspannungsschutzeinrichtung mit Überwachungs- und Kommunikationsfunktion insbesondere für die Informations- und Prozessindustrie anzugeben, die sich nicht auf eine Fernsignalisierung des Betriebszustandes eingesetzter Überspannungsableiter beschränkt, sondern vielmehr diagnostizierte Messwerte und Daten für eine externe Verwendung zur Verfügung stellt.

Die Lösung der Aufgabe der Erfindung erfolgt mit der Lehre gemäß Patentanspruch 1, wobei die Unteransprüche mindestens zweckmäßige Ausgestaltungen und Weiterbildungen darstellen.

Demnach wird von einer Überspannungsschutzeinrichtung mit Überwachungs- und Kommunikationsfunktion ausgegangen. Die erfindungsgemäße Überspannungsschutzeinrichtung ist insbesondere für den Einsatz in der Informations- und Prozessindustrie geeignet und geht von mindestens einem Überspannungsableiter mit Eigendiagnoseeinheit sowie einer drahtlosen und/oder drahtgebundenen Standardschnittstelle zur Datenübertragung bzw. Datenübermittlung aus.

Erfindungsgemäß weist die Überspannungsschutzeinrichtung mindestens eine weitere Zusatzbaugruppe auf. Diese weitere Zusatzbaugruppe dient zur Erfassung des Verhaltens und/oder der Eigenschaften eines angeschlossenen elektrischen Netzes bzw. einer angeschlossenen elektrischen Energiequelle.

Damit können neben Belastungswerten der Komponenten der Überspannungsableiter, wie Temperatur, Stoßstrom, Folgestrom, Ansprechhäufigkeit usw. auch Informationen ausgewertet werden, die von integrierten Power-Quality-Modulen ableitbar sind. Hier seien beispielsweise Oberwellen, Spannungseinbrüche oder dergleichen genannt.

Die Standardschnittstelle ist entgegen bisheriger Lösungen nicht nur unidirektional sondern bidirektional organisiert und ermöglicht einen entsprechend bidirektionalen Daten- und Befehlsaustausch sowohl zu einem übergeordneten Leitsystem als auch zwischen dem übergeordneten Leitsystem und der eigentlichen Überspannungsschutzeinrichtung, wodurch ein Datenaustausches zwischen mehreren erfindungsgemäßen Überspannungsschutzeinrichtungen unter Bildung eines Systems von gekoppelten Überspannungseinrichtungen organisiert ist, die darüber hinaus sich gegenseitig oder unter Zwischenschaltung eines Leitsystems parametrieren.

Es ermöglicht also die Erfindungslehre eine system- bzw. anwenderabhängige Parametrierung einzelner Funktionen der eingesetzten Überspannungsableiter aber auch der integrierten Zusatzbaugruppen.

Derartige parametrierbare Eigenschaften umfassen die Ansprechspannung, die TOV-Werte zur Auslösung, Einstellwerte für die Überstromschutzfunktion und des Kurzschlussstromes im Netz.

Wie bereits erwähnt, besteht durch die erfindungsgemäße Lehre die Möglichkeit, dass die Überspannungsschutzeinrichtungen untereinander, aber auch mit einer Zentraleinheit unter Nutzung der bidirektionalen Schnittstelle kommunizieren.

Ein weiterer erfindungsgemäßer Ansatz besteht darin, dass die vorerwähnte Parametrierung auch bezüglich nachgeordneter, zu schützender Endgeräte realisiert ist. Werden beispielsweise kritische Oberwellenspektren an den jeweiligen Installationsorten durch die Zusatzbaugruppe zur Erfassung diesbezüglicher Eigenschaften ermittelt, dann können aktive Filter vor oder in den Endgeräten eingestellt, das heißt parametriert werden. Diesbezüglich geänderte Parametrierungsdaten sind dann ebenfalls unter Nutzung der bidirektionalen Schnittstelle an ein übergeordnetes Leit- und Auswertesystem übertragbar.

In Weiterbildung der Erfindung besteht die Möglichkeit, dass die jeweiligen Überspannungsschutzeinrichtungen einen integrierten Zugang zum Internet aufweisen, um diesbezüglich eine Kommunikation unter Nutzung einer klassischen App zu gestatten, so dass Meldungen auch an ein Smartphone, ein Laptop, ein Tablet, einen Personal Computer oder dergleichen ausgegeben werden können bzw. über derartige Geräte eine Dateneingabe erfolgen kann.

Letztendlich schafft die erfindungsgemäße Lösung die Möglichkeit der Ausbildung eines Systems von Überspannungsschutzeinrichtungen in einem bestimmten Netz mit Monitoring-Funktion. Hierdurch ist eine intelligente Aufgabenteilung eingesetzter Überspannungsableiter nebst erweiterten Schutzmöglichkeiten für Endgeräte realisierbar.

Die erfindungsgemäße Überspannungsschutzeinrichtung besitzt demnach eine integrierte Eigendiagnosefunktion aller für die Überspannungsschutzeinrichtung relevanten Belastungsparameter. Dies können zum Beispiel stoßstrombedingte Belastungen, Temperaturbelastungen, TOV-Spannungen und ähnliches sein.

Diese Parameter bilden insgesamt die Belastung und die sich ergebende Restlebensdauer des entsprechenden Gerätes bzw. der Überspannungsschutzeinrichtung ab. Die genannten Parameter werden erfindungsgemäß an übergeordnete Systemeinrichtungen gemeldet und dort ausgewertet, und zu Wartungs- und Servicezwecken aber auch für statistische Untersuchungen genutzt.

Die erfindungsgemäßen Überspannungsschutzeinrichtungen verfügen ebenso über funktionsintegrierte Baugruppen, welche wie bereits dargelegt, netzrelevante Informationen, zum Beispiel Oberwellen, Impedanzverhältnisse des speisenden Netzes, Spannungsfluktuationen und ähnliches erfassen. Diese netzrelevanten Informationen dienen zum einen der Eigennutzung, das heißt der speziellen Parametrierung und Anpassung der Schutzeinrichtungen. Andererseits dienen die gewonnenen Informationen auch der Fremdnutzung. So können beispielsweise vor Ort aufgenommene Informationen über Oberwellen, Spannungsfluktuationen und Impedanzverhältnisse an Energieversorgungsunternehmen weitergeleitet und dort ausgewertet werden, um einen komplexen Blick bezogen auf das relevante Netz zu erhalten.

Durch die große Verbreitung von Überspannungsschutzeinrichtungen an vielen Netzpositionen ergibt sich eine besonders einfache Möglichkeit, diesen umfassenden Überblick über die jeweilige Netzsituation in Echtzeit zu erhalten.

Ein weiterer erfindungsgemäßer Aspekt besteht in der Eigenparametrierung. Hierunter wird die Möglichkeit des Anwenders verstanden, Eigenschaften der Schutzgeräte nach Bedarf und in Abhängigkeit von der Netzsituation über geeignete Kommunikationsschnittstellen einzustellen bzw. vorzugeben.

Dies können beispielsweise Werte sein, die die Ansprechcharakteristik, das heißt den Schutzpegel der Überspannungsschutzeinrichtung, betreffen, und zwar in Abhängigkeit von jeweiligen Endgeräten. Weiterhin ist es möglich, dass die ermittelten Impedanzdaten dazu benutzt werden, die Auslösecharakteristik zugeordneter Überspannungsschutzeinrichtungen einzustellen, aber auch eine einmal getroffene Einstellung zu verändern. Dies ist immer dann hilfreich, wenn in den Netzen volatile Kurzschlussstromwerte auftreten, und zwar insbesondere in Netzen mit hohem Anteil an regenerativen Energiequellen.

Mit dem Einsatz der erfindungsgemäßen Überspannungsschutzeinrichtungen ergibt sich nicht nur ein verbesserter Schutz des jeweiligen Endgerätes, sondern es kann ein komplexes System mit Rückmeldung über die Netzeigenschaften realisiert werden.

## Patentansprüche

1. System enthaltend mehrere vernetzte Überspannungsschutzeinrichtungen mit Überwachungs- und Kommunikationsfunktion für die Informations- und Prozessindustrie, mit
mindestens einem Überspannungsableiter mit Eigendiagnoseeinheit sowie einer drahtlosen und/oder drahtgebundenen Standardschnittstelle zur Datenübermittlung,
wobei eine weitere Zusatzbaugruppe mit Mitteln zur Erfassung des Verhaltens und/oder der Eigenschaften einer angeschlossenen elektrischen Energiequelle und netzrelevanter Eigenschaften vorgesehen ist und
über die Standardschnittstelle ein bidirektionaler Daten- und Befehlsaustausch sowohl zu und zwischen einem übergeordneten Leitsystem als auch zwischen den mehreren Überspannungsschutzeinrichtungen erfolgt unter Bildung des Systems von gekoppelten Überspannungsschutzeinrichtungen und
eine Parametrierung nachgeordneter, zu schützender Endgeräte und/oder der Überspannungsschutzeinrichtungen realisiert ist,
wobei diese Parametrierung die Einstellung von aktiven Filtern vor oder in den Endgeräten und/oder der Ansprechspannung, der TOV-Werte zur Auslösung, der Einstellwerte für die Überstromschutzfunktion oder des Kurzschlussstroms im Netz umfasst, und
wobei die Parametrierung das gegenseitige oder unter Zwischenschaltung des Leitsystems stattfindende Parametrieren der Überspannungsschutzeinrichtungen umfasst.

2. System nach Anspruch 1, **dadurch gekennzeichnet, dass** dieses eine Einrichtung zur unmittelbaren Internet-Kommunikation aufweist.

3. System nach Anspruch 1 oder 2, **dadurch gekennzeichnet, dass** die Zusatzbraugruppe dazu eingerichtet ist, Informationen auszuwerten, die von integrierten Power-Quality-Modulen ableitbar sind.

## Claims

1. A system including a plurality of interlinked overvoltage protection devices having monitoring and communication functions for the information and process industries, comprising
at least one surge arrester having a self-diagnostics unit and a wireless and/or wired standard interface for data transmission,
wherein a further additional module is provided which has means to detect the behavior and/or the properties of a connected electrical energy source and network-relevant properties,
a bidirectional exchange of data and commands both to and between a higher-level control system and also among the plurality of overvoltage protection devices takes place via the standard interface to form the system of coupled overvoltage protection devices, and
a parametrization of lower-level terminal devices to be protected and/or the overvoltage protection devices is realized,
wherein said parametrization comprises setting of active filters upstream of or in the terminal devices and/or of the response voltage, the TOV values for tripping, the setting values for the overcurrent protection function or the short-circuit current in the network, and
wherein the parametrization comprises mutual parametrizing of the overvoltage protection devices or parametrizing of the overvoltage protection devices taking place with the control system interconnected.

2. The system according to claim 1, **characterized in that** it includes a device for direct Internet communication.

3. The system according to claim 1 or 2, **characterized in that** the additional module is configured to evaluate information which is derivable from integrated power quality modules.

## Revendications

1. Système comprenant plusieurs dispositifs de protection contre les surtensions interconnectés, dotés de fonctions de surveillance et de communication, destiné à l'industrie de l'information et des processus, comprenant
au moins un parafoudre muni d'une unité d'autodiagnostic ainsi que d'une interface standard sans fil et/ou filaire pour la transmission de données,
un module supplémentaire étant prévu avec des moyens pour détecter le comportement et/ou les caractéristiques d'une source d'énergie électrique raccordée ainsi que des caractéristiques pertinentes pour le réseau, et
un échange bidirectionnel de données et de commandes s'effectue via l'interface standard, tant vers et entre un système de contrôle de niveau supérieur qu'entre les différents dispositifs de protection contre les surtensions, formant ainsi un système de dispositifs de protection contre les surtensions couplés, et
un paramétrage des terminaux en aval à protéger et/ou des dispositifs de protection contre les surtensions est réalisé,
ce paramétrage comprenant le réglage de filtres actifs en amont ou dans les terminaux et/ou de la tension de déclenchement, des valeurs TOV pour le déclenchement, des valeurs de réglage pour la fonction de protection contre les surintensités ou du courant de court-circuit dans le réseau, et
le paramétrage comprenant le paramétrage mutuel des dispositifs de protection contre les surtensions ou le paramétrage de ceux-ci avec interposition du système de commande.

2. Système selon la revendication 1, **caractérisé en ce qu'**il comporte un dispositif permettant une communication directe avec Internet.

3. Système selon la revendication 1 ou 2, **caractérisé en ce que** le module supplémentaire est conçu pour analyser les informations pouvant être dérivées de modules de qualité de l'énergie intégrés.
